(19) **Europäisches Patentamt**
**European Patent Office**
**Office européen des brevets**

(11) **EP 1 770 868 B1**

(12) **EUROPÄISCHE PATENTSCHRIFT**

(45) Veröffentlichungstag und Bekanntmachung des Hinweises auf die Patenterteilung:
**02.04.2008 Patentblatt 2008/14**

(51) Int Cl.:
*H04B 1/30* *(2006.01)*   *H04L 27/22* *(2006.01)*
*H03D 3/00* *(2006.01)*

(21) Anmeldenummer: **06019839.7**

(22) Anmeldetag: **22.09.2006**

(54) **Vorrichtung zum Überführen eines komplexwertigen Bandpasssignals in ein digitales Basisbandsignal**

Device for converting a complex-valued passband signal into a digital baseband signal

Dispositif pour convertir un signal valeurs complexes de bande passante dans un signal digital de bande de base

(84) Benannte Vertragsstaaten:
**DE FR**

(30) Priorität: **28.09.2005 DE 102005046245**

(43) Veröffentlichungstag der Anmeldung:
**04.04.2007 Patentblatt 2007/14**

(73) Patentinhaber: **ATMEL Germany GmbH**
**74072 Heilbronn (DE)**

(72) Erfinder:
• **Haentzschel, Dirk, Dipl.-Ing.**
**01833 Dürröhrsdorf-Dittersbach (DE)**
• **Hanusch, Thomas, Dipl.-Ing.**
**01640 Coswig (DE)**
• **Schmidt, Michael, Dr.-Ing.**
**01324 Dresden (DE)**

(74) Vertreter: **Müller, Wolf-Christian**
**Patentanwalt**
**Maaßstraße 32/1**
**69123 Heidelberg (DE)**

(56) Entgegenhaltungen:
**WO-A2-02/43259**

• **CHOI P ET AL: "AN EXPERIMENTAL COIN-SIZED RADIO FOR EXTREMELY LOW-POWER WPAN (IEEE 802.15.4) APPLICATION AT 2.4 GHZ" IEEE JOURNAL OF SOLID-STATE CIRCUITS, IEEE SERVICE CENTER, PISCATAWAY, NJ, US, Bd. 38, Nr. 12, Dezember 2003 (2003-12), Seiten 2258-2268, XP001221476 ISSN: 0018-9200**

EP 1 770 868 B1

**Beschreibung**

Die vorliegende Erfindung betrifft eine Vorrichtung zum Überführen eines komplexwertigen Bandpaßsignals in ein digitales Basisbandsignal. Die Erfindung betrifft weiterhin eine Sende-/Empfangsvorrichtung und eine integrierte Schaltung mit einer solchen Vorrichtung.

Die Erfindung liegt auf dem Gebiet der Telekommunikation. Sie liegt insbesondere auf dem Gebiet von digitalen Telekommunikationssystemen, bei denen eine Vielzahl von sende-/Empfangsvorrichtungen nach einem Multiplex-Zugriffsverfahren auf ein bestimmtes Frequenzband oder einen Teil davon zugreifen. In der Empfangseinheit jeder Sende-/Empfangsvorrichtung ist hierbei ein Bandpaßsignal, wie z.B. ein über eine Antenne empfangenes Funksignal bzw. ein daraus abgeleitetes Zwischenfrequenzsignal, in ein digitales Basisbandsignal zu überführen, bevor die darin enthaltenen, von einer anderen Sende-/Empfangsvorrichtung stammenden Datenwerte detektiert werden können.

Wenngleich prinzipiell auf beliebige drahtlose oder drahtgebundene digitale Telekommunikationssysteme anwendbar, werden die vorliegende Erfindung sowie die ihr zugrunde liegende Problematik nachfolgend anhand eines "Zig-Bee"-Kommunikationssystems gemäß IEEE 802.15.4 erläutert.

Zur drahtlosen Übertragung von Informationen über relativ kurze Distanzen (ca. 10m) können sog. "Wireless Personal Area Networks" (WPANs) verwendet werden. Im Gegensatz zu "Wireless Local Area Networks" (WLANs) benötigen WPANs zur Datenübertragung wenig oder sogar keine Infrastruktur, so daß kleine, einfache, energieeffiziente und kostengünstige Geräte für einen breiten Anwendungsbereich implementiert werden können.

Der Standard IEEE 802.15.4 spezifiziert niederratige WPANs, die mit Rohdatenraten bis 250 kbit/s und ortsfesten oder mobilen Geräten für Anwendungen in der industriellen Überwachung und Steuerung, in Sensornetzwerken, in der Automatisierung, sowie im Bereich der Computerperipherie und für interaktive Spiele geeignet sind. Neben einer sehr einfachen und kostengünstigen Implementierbarkeit der Geräte ist für derartige Anwendungen ein extrem geringer Energiebedarf der Geräte von entscheidender Bedeutung. So werden mit diesem Standard Batterielaufzeiten von mehreren Monaten bis mehrere Jahre angestrebt.

Auf der Ebene der physikalischen Schicht spezifiziert IEEE 802.15.4 im nahezu weltweit verfügbaren ISM-Band (industrial, scientific, medical) um 2,4 GHz insgesamt 16 (Trägerfrequenz-)Kanäle mit einem Kanalraster von 5 MHz. Für Rohdatenraten von 250 kbit/s ist in diesen Kanälen eine Symbolrate von 62,5 ksymbol/s und eine Bandspreizung (spreading) mit einer Chiprate von $fC=2$ Mchip/s sowie eine Offset-QPSK-Modulation vorgesehen (quarternary phase shift keying).

Das im ISM-Band übertragene Bandpaß-Funksignal ist empfängerseitig zunächst in ein digitales Basisbandsignal zu überführen (d.h. zu transformieren). Während andere Schaltungseinheiten der Empfangseinheit erst nach erfolgreicher Synchronisation aktiviert werden müssen, muß die Vorrichtung zum Überführen des Bandpaßsignals in das Basisband schon während der sog. Horchphase ("RX Listen Mode") auf die Präambelsequenz aktiv sein. Aus diesem Grund ist der Energieverbrauch dieser Vorrichtung sehr wichtig für den Energieverbrauch der gesamten Sende-/Empfangsvorrichtung.

Bekannte Vorrichtungen zum Überführen eines Bandpaßsignals in ein digitales Basisbandsignal erfordern zwei Analog-/Digital-Wandler zur Digitalisierung des Realteils und des imaginärtells des in das Basisband oder einen Zwischenfrequenzbereich verschobenen komplexwertigen Signals. Nachteilig sind hierbei der hohe Implementierungsaufwand und der erhöhte Energieverbrauch im Betrieb. Hinzu kommen oft Arithmetikeinheiten wie Filter etc. zur Durchführung zeitdiskreter arithmetischer Operationen wie Additionen und/oder Multiplikationen, was ebenfalls sowohl hinsichtlich des Reallslerungsaufwandes der entsprechenden Sende-/Empfangsvorrichtung als auch im Hinblick auf den Energieverbrauch im Betrieb nachteilig ist.

Aus der WO 02/43259 A2 ist ein Low-IF und zero-IF betreibbarer Funkempfänger bekannt, bei dem durch eine Quantisierung nur eines der Inphase- und Quadratursignale der IF Ausgabe des Empfängers auf komplexe oder Analog-Digital-wandler und komplexe Kanalfliter verzichtet werden kann.

Vor diesem Hintergrund liegt der Erfindung die Aufgabe zugrunde, eine Vorrichtung zum Überführen eines komplexwertigen Bandpaßsignals in ein digitales Basisbandsignal anzugeben, die weder zwei Analog-/Digital-Wandler noch Arithmetikeinheiten zur Durchführung zeitdiskreter arithmetischer Operationen erfordert und es so ermöglicht, sende-/Empfangsvorrichtungen einfach und kostengünstig zu implementieren und energiesparend zu betreiben.

Erfindungsgemäß wird diese Aufgabe gelöst durch eine Vorrichtung, eine Sende-/Empfangsvorrichtung und eine integrierte Schaltung mit den Merkmalen der Patentansprüche 1, 11, bzw. 12.

Die erfindungsgemäße Vorrichtung weist folgende Einheiten auf: a) eine analoge Filtereinheit, die ausgebildet ist, das komplexwertige Bandpaßsignal derart zu filtern, daß Signalanteile außerhalb des Nutzbandes unterdrückt werden, vom gefilterten Signal nur den Realteil zu bilden und ein reellwertiges Bandpaßsignal bereitzustellen, b) genau einen mit der analogen Filtereinheit verbundenen Analog-Digital-Wandler, der ausgebildet ist, das reellwertige Bandpaßsignal in ein digitales Signal mit ein Bit breiten Abtastwerten zu überführen, c) eine mit dem Analog-Digital-Wandler verbundene und als Lookup-Table ausgestaltete digitale Filtereinheit, die ausgebildet ist, ein komplexwertiges gefiltertes Signal bereitzustellen, indem das digitale Signal mittels einer komplexwertigen FIR-Filterung derart gefiltert wird, daß Signalanteile außerhalb des Nutzbandes unterdrückt werden, d) eine mit der digitalen Filtereinheit verbundene Abtastratenreduktionseinheit, die ausgebildet ist, das komplexwertige gefilterte Signal in seiner Abtastrate zu reduzieren und ein ratenreduziertes Signal bereitzustellen, und e) eine mit der Abtastratenreduktionseinheit verbundene Mischereinheit, die ausgebildet ist, das ratenreduzierte Signal in das digitale Basisbandsignal zu überführen.

Die erfindungsgemäße Sende-/Empfangsvorrichtung und die erfindungsgemäße integrierte Schaltung weisen jeweils eine solche Vorrichtung auf.

Das Wesen der Erfindung besteht darin, ein *reellwertiges* Bandpaßsignal (Zwischenfrequenzsignal) abzuleiten, das mit nur *einem* Analog-Digital-Wandler mit einer Auflösung von nur *einem* Bit pro Abtastwert digitalisiert wird. *Bevor* das resultierende digitale (Zwischenfrequenz-)Signal ins Basisband überführt wird, erfolgt eine *komplexwertige FIR-Filterung* mittels einer *als Lookup-Table* ausgeführten digitalen Filtereinheit. Weiterhin wird das komplexwertige gefilterte Signal *in seiner Abtastrate reduziert, bevor* es schließlich mittels einer Mischereinheit in das digitale Basisbandsignal überführt wird. Eine solche Vorrichtung benötigt weder zwei Analog-Digital-Wandler noch Arithmetikeinheiten zum Ausführen von zeitdiskreten Multiplikationen oder Additionen und ermöglicht es so, Sende-/Empfangsvorrichtungen einfach und kostengünstig zu implementieren und energiesparend zu betreiben. Da erfindungsgemäß im wesentlichen nur das Input-/Output-Verhalten implementiert wird, entfallen auch die ansonsten mit Arithmetikeinheiten wie adder trees" etc. verbundenen Signallaufzeiten (Latenzzeiten), was insbesondere bei sehr hohen Datenraten vorteilhaft ist.

Vorteilhafte Ausgestaltungen und Weiterbildungen der Erfindung sind den abhängigen Ansprüchen sowie der Beschreibung unter Bezugnahme auf die Zeichnung zu entnehmen.

In einer vorteilhaften Ausgestaltung ist die analoge Filtereinheit ausgebildet, das komplexwertige Bandpaßsignal mittels einer Butterworth-Filterung dritter Ordnung zu filtern. Eine solche analoge Filtereinheit unterdrückt Nachbarkanal- und Rauschsignale hinreichend gut und ist darüber hinaus einfach zu realisieren und energiesparend zu betreiben und ermöglicht es so, Sende-/Empfangsvorrichtungen einfach und kostengünstig zu implementieren und energiesparend zu betreiben.

In einer weiteren vorteilhaften Ausgestaltung ist die analoge Filtereinheit ausgebildet, das reellwertige Bandpaßsignal zu bilden, indem die Werte des Realteils des gefilterten Signals verstärkt und auf einen Maximalwert begrenzt werden. Hierdurch kann am Eingang des Analog-Digital-Wandlers ein größerer Dynamikbereich abgedeckt werden. Da nur die Werte des Realteils des gefilterten Signals, d.h. nur *ein* reellwertiges Signal, verstärkt werden, wird vorteilhaft ein niedriger Energieverbrauch sowie ein herabgesetzter Implementierungsaufwand erreicht.

Vorzugsweise ist der Analog-Digital-Wandler ausgebildet, das reellwertige Bandpaßsignal mit einer Abtastrate von 16 Msps abzutasten. Durch diese Abtastrate im achtfachen Chiptakt wird erreicht, daß bei einer Auflösung von einem Bit einerseits die Empfängerempfindlichkeit hinreichend hoch ist und andererseits insbesondere die digitale Filtereinheit einfach zu realisieren ist.

In einer vorteilhaften Ausgestaltung weist die digitale Filtereinheit ein mit dem Analog-Digital-Wandler verbundenes binäres Schieberegister und einen mit dem binären Schieberegister und der Abtastratenreduktionseinheit verbundenen Speicher auf. Hierbei ist das binäre Schieberegister vorzugsweise ausgebildet, fünf Werte des digitalen Signals zu speichern, während der Speicher vorzugsweise ausgebildet ist, 64 komplexe Werte zu speichern. Diese Realisierung der digitalen Filtereinheit ist besonders einfach und betriebsenergiesparend.

In einer weiteren vorteilhaften Ausgestaltung ist die Mischereinheit ausgebildet, das Vorzeichen von Real- und/ oder Imaginärteil eines Wertes des ratenreduzierten Signals zu wechseln. Hierdurch läßt sich die Mischereinheit sehr einfach realisieren und energiesparend betreiben.

In einer bevorzugten Weiterbildung ist die Abtastratenreduktionseinheit ausgebildet, das komplexwertige gefilterte Signal in seiner Abtastrate um einen Faktor von zwei zu reduzieren. Die Mischereinheit ist hierbei ausgebildet, den Realteil mit dem Imaginärteil eines Wertes des ratenreduzierten Signals zu tauschen und/oder das Vorzeichen von Real- und/oder Imaginärteil des Wertes zu wechseln. Auf diese Weise wird das gefilterte Signal einfach und energiesparend in das Basisband transformiert. Das resultierende digitale Basisbandsignal weist Abtastwerte mit einer Rate auf, die dem vierfachen Chiptakt entspricht, so daß eine zeitliche Drift infolge einer Frequenzabweichung zwischen Sender- und Empfängeroszillator vorteilhaft gut und ohne zusätzliche Interpolationsfilter ausgeglichen werden kann.

In einer weiteren vorteilhaften Weiterbildung ist die Abtastratenreduktionseinheit ausgebildet, das komplexwertige gefilterte Signal in seiner Abtastrate um einen Faktor von vier zu reduzieren. Die Mischereinheit ist in diesem Falle ausgebildet, das vorzeichen von Real- und Imaginärteil jedes zweiten Wertes des ratenreduzierten Signals zu wechseln. Auf diese Weise wird das gefilterte Signal einfach und energiesparend in das Basisband transformiert.

Vorzugsweise weist das komplexwertige (und damit auch das reellwertige) Bandpaßsignal eine Mittenfrequenz von im wesentlichen 2 MHz auf. Ein solcher (niedriger) Wert der Zwischenfrequenz wirkt sich positiv auf den Realisierungsaufwand und den Energieverbrauch der Sende-/Empfangs-vorrichtung aus.

Die Erfindung wird nachfolgend anhand der in den schematischen Figuren der Zeichnung angegebenen Ausführungsbeispiele näher erläutert. Hierbei zeigen

Fig. 1 ein Beispiel eines Wireless Personal Area Network" (WPAN) nach IEEE 802.15.4 mit erfindungsgemäßen Sende-/Empfangsvorrichtungen;

Fig. 2 Ausführungsbeispiele einer Empfangseinheit einer Sende-/Empfangsvorrichtung nach IEEE 802.15.4 mit erfindungsgemäßer Vorrichtung; und

Fig. 3 spektrale Leistungsdichten verschiedener Signale im ersten Ausführungsbeispiel aus Figur 2.

In den Figuren sind gleiche und funktionsgleiche Elemente und Signale - sofern nicht anders angegeben - mit denselben Bezugszeichen versehen.

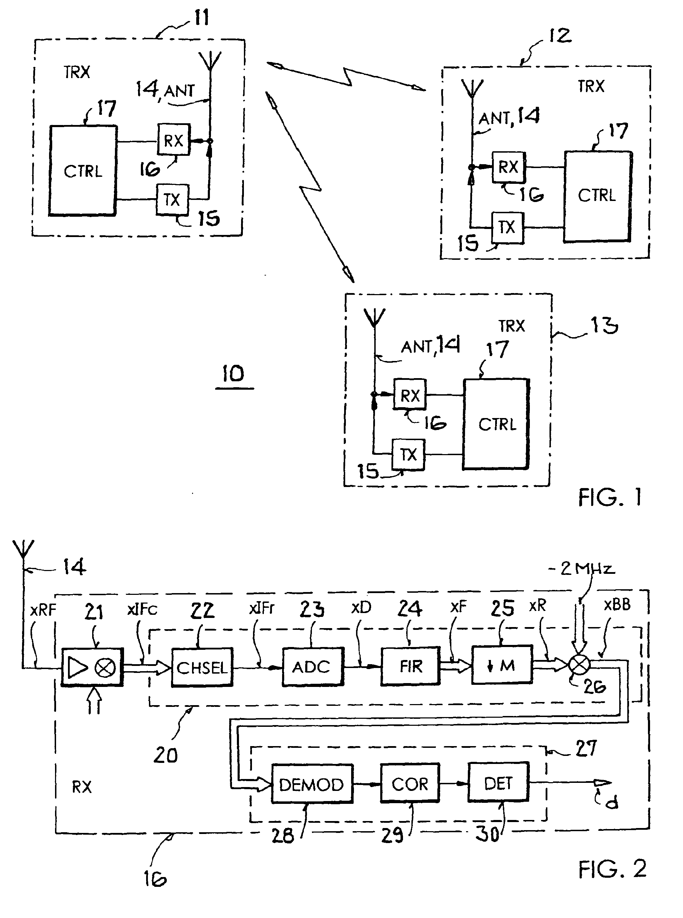

Figur 1 zeigt ein Beispiel eines "Wireless Personal Area Networks" (WPAN) 10 nach dem IEEE-Standard 802.15.4. Es umfaßt drei Sende-/Empfangsvorrichtungen (transceiver, TRX) 11-13 in Form von ortsfesten oder mobilen Geräten, die mittels Funksignalen drahtlos Informationen austauschen. Bei der Sende-/Empfangsvorrichtung 11 handelt es sich um ein sog. Vollfunktionsgerät, das die Funktion des WPAN-Koordinators übernimmt, während es sich bei den Sende-/Empfangsvorrichtungen 12, 13 um sog. Teilfunktionsgeräte handelt, die dem Vollfunktionsgerät 11 zugeordnet sind und nur mit diesem Daten austauschen können. Neben der in Figur 1 dargestellten sternförmigen Netzwerktopologie, bei der die bidirektionale Datenübertragung nur zwischen jeweils einem der Teilfunktionsgeräte 12, 13 und dem Vollfunktionsgerät 11, nicht jedoch zwischen den Teilfunktionsgeräten 12, 13 erfolgen kann, sieht der Standard auch sog. "Peer-to-Peer"-Topologien vor, bei denen sämtliche Vollfunktionsgeräte mit jeweils allen anderen Vollfunktionsgeräten kommunizieren können.

Die Sende-/Empfangsvorrichtungen 11-13 umfassen jeweils eine Antenne 14, eine mit der Antenne verbundene Sendeeinheit (transmitter, TX) 15, eine mit der Antenne verbundene Empfangseinheit (receiver, RX) 16 und eine mit der Sende- und der Empfangseinheit verbundene Kontrolleinheit (control unit, CTRL) 17 zur Steuerung der Sende- und Empfangseinheiten 15, 16. Weiterhin beinhalten die Sende-/Empfangsvorrichtungen 11-13 jeweils eine in Figur 1 nicht dargestellte Energieversorgungseinheit in Form einer Batterie etc. zur Energieversorgung der Einheiten 15-17, sowie eventuell weitere Komponenten wie Sensoren, Aktoren etc..

Im folgenden wird davon ausgegangen, daß die Datenübertragung im ISM-Band (industrial, scientific, medical) bei 2,4 GHz erfolgt.

Die Sendeeinheit 15 jeder Sende-/Empfangsvorrichtung wandelt den jeweils zu sendenden Datenstrom gemäß IEEE 802.15.4 in ein über ihre Antenne 14 abzustrahlendes Funksignal um, indem der jeweils zu sendende Datenstrom (Rohdatenrate: 250 kbit/s) zunächst in vier Bit breite Symbole (Symbolrate: 62,5 ksymbol/s) und diese in aufeinanderfolgende symbolwertspezifische PN-Sequenzen (pseudo noise) aus jeweils 32 Chips umgesetzt werden (Chiprate: $f_C = 2$ Mchip/s).

Der Spreizgewinn (spreading gain) beträgt damit 8. Die aufeinanderfolgenden PN-Sequenzen werden anschließend - mit Halbsinus-Impulsformung - Offset-QPSK-moduliert (quarternary phase shift keying), spektral in einen der 16 Kanäle im ISM-Band verschoben und schließlich für die Übertragung verstärkt.

Die Empfangseinheit 16 jeder Sende-/Empfangsvorrichtung wandelt ein von ihrer Antenne 14 empfangenes und von der Sendeeinheit einer zweiten Sende-/ Empfangsvorrichtung nach IEEE 802.15.4 erzeugtes Funksignal möglichst fehlerfrei in die gesendeten Daten um, indem das empfangene Funksignal unter anderem gefiltert, in das Basisband transformiert, demoduliert und die Daten detektiert (entschieden) werden. Neben dem Nutzkanalanteil, d.h. dem von der zweiten Sende-/Empfangsvorrichtung im gewünschten Kanal übertragenen Sendesignal, kann das empfangene Signal Nachbarkanalanteile aufweisen, d.h. von dritten Sende-/Empfangsvorrichtungen in spektral benachbarten Kanälen übertragene Sendesignale.

Die Sendeeinheit 15 und die Empfangseinheit 16 einer Sende-/Empfangsvorrichtung sind hierbei Teil einer (in Figur 1 nicht dargestellten) integrierten Schaltung, z.B. eines ASIC (application specific integrated circuit) oder eines ASSP (application specific standard product), während die Kontrolleinheit 17 durch einen (ebenfalls nicht dargestellten) Mikrocontroller realisiert ist. Vorteilhaft weist die Sende-/Empfangsvorrichtung nur eine (z.B. als ASIC oder ASSP ausgeführte) integrierte Schaltung auf, die die Funktionen der Sendeeinheit 15, der Empfangseinheit 16 und der Kontrolleinheit 17 wahrnimmt.

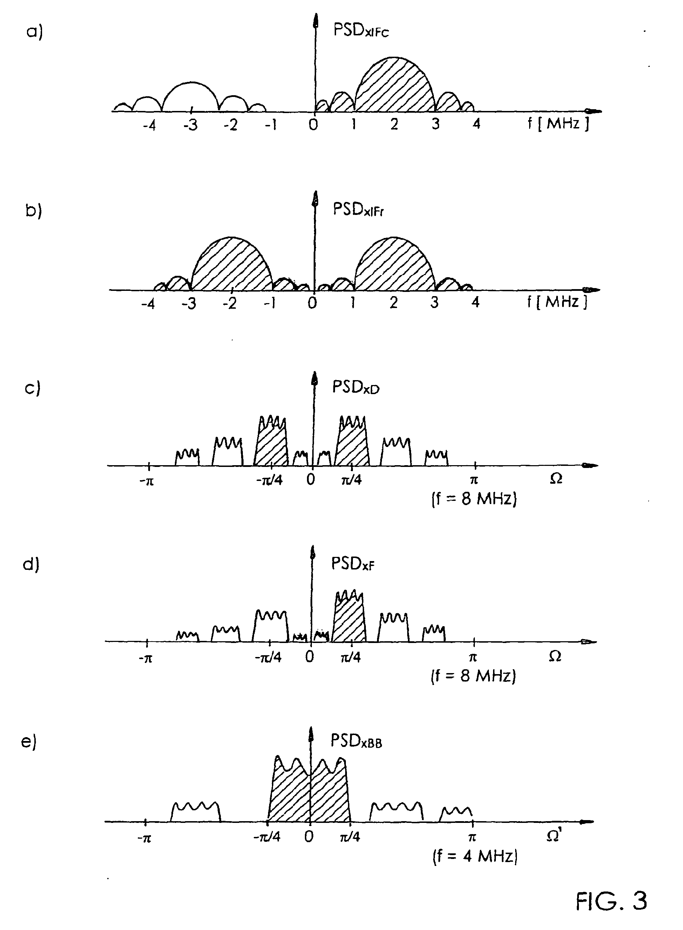

Figur 2 zeigt ein Blockschaltbild einer Empfangseinheit (RX) 16 mit einer erfindungsgemäßen Vorrichtung 20 zum Überführen eines komplexwertigen Bandpaßsignals in ein digitales Basisbandsignal. Figur 3 zeigt schematisch die spektralen Leistungsdichten verschiedener Signale aus Figur 2.

Gemäß Figur 2 beinhaltet die Empfangseinheit 16 eine mit der Antenne 14 verbundene Verstärker-/Mischereinheit 21, die der Verstärker-/Mischereinheit 21 nachgeschaltete erfindungsgemäße Vorrichtung 20 sowie eine der Vorrichtung 20 nachgeschaltete Datendetektionseinheit 27. Anhand des von der Verstärker-/ Mischereinheit 21 bereitgestellten komplexwertigen Bandpaßsignals $x_{IFc}$ generiert die Vorrichtung 20 ein ebenfalls komplexwertiges digitales Basisbandsignal $x_{BB}$, das nachfolgend in der Datendetektionseinheit 27 demoduliert und detektiert (entschieden) wird, um die ursprünglich gesendeten Datenwerte wiederherzustellen. Komplexwertige Signale bzw. Leitungsverbindungen zur Übertragung von komplexwertigen Signalen sind in den Figuren durch Pfeile mit Doppellinien dargestellt.

Die Vorrichtung 20 weist folgende in Serie geschaltete Funktionsblöcke auf: eine analoge Filtereinheit (CHSEL) 22, einen Analog/Digital-Wandler (ADC) 23, eine digitale Filtereinheit (FIR) 24, eine Abtastratenreduktionseinheit 25 und eine Mischereinheit 26. Die analoge Filtereinheit 22 ist hierbei eingangsseitig mit der Verstärker-/Mischereinheit 21 verbunden, während die Mischereinheit 26 einen mit der Datendetektionseinheit 27 verbundenen Ausgang aufweist.

Die Datendetektionseinheit 27, die zum Detektieren der gesendeten Datenwerte ausgebildet ist, weist eine eingangsseitig mit der Mischereinheit 26 der Vorrichtung 20 verbundene Demodulationseinheit 28, eine nachgeschaltete Korrelationseinheit 29 und eine der Korrelationseinheit 29 nachgeschaltete Detektionseinheit 30 auf.

Das von der Antenne 14 empfangene reellwertige Funksignal XRF, das - wie oben mit Bezug auf Figur 1 beschrieben - evtl. einen oder mehrere spektral beabstandete Nachbarkanalanteile aufweisen kann, wird in der Verstärker-/Mischereinheit 21 zunächst mittels eines rauscharmen Verstärkers (LNA) verstärkt und durch ein Polyphasenfilter in eine Inphasenkomponente (I) und eine ouadraturphasenkomponente (Q) zerlegt. Das so gebildete komplexwertige Empfangssignal (mit Realteil I und Imaginärteil Q) wird anschließend mit Hilfe von zwei Mischern in einen Zwischenfrequenzbereich um 2 MHz umgesetzt und so das Zwischenfrequenzsignal XIFC gebildet (IF, intermediate frequency). Beim Zwischenfrequenzsignal XIFC handelt es sich um ein komplexwertiges Bandpaßsignal. Die spektrale Leistungsdichte (power spectral density, PSD) des Zwischenfrequenzsignals xIFc ist in Figur 3a schematisch dargestellt. Aus Figur 3a ist zu ersehen, daß infolge der Umsetzung in den Zwischenfrequenzbereich die Mittenfrequenz des (schraffiert dargestellten) Nutzkanalanteils bei der Zwischenfrequenz fIF= 2MHz und die Mittenfrequenz des im Spektrum nächstliegenden linken Nachbarkanalanteils (nicht schraffiert dargestellt) wegen des Kanalrasters von 5 MHz bei fIF - 5 MHz = -3 MHz liegt. Aufgrund des im Vergleich zur Trägerfrequenz (ca. 2,4 GHz) niedrigen Wertes der Zwischenfrequenz fIF von 2 MHz wird die in Figur 2 dargestellte Empfangseinheit 16 als "low IF"-Empfangseinheit bezeichnet.

Die analoge Filtereinheit (CHSEL) 22 ist ausgebildet, ein reellwertiges Bandpaßsignal xIFr abzuleiten, indem das komplexwertige Bandpaßsignal xIFc derart gefiltert wird, daß Signalanteile außerhalb des Nutzbandes, d.h. des Nutzkanal-Frequenzbandes unterdrückt werden, und vom gefilterten Signal der Realteil gebildet wird. Die Filtereinheit 22 dient einerseits der Selektion des gewünschten Kanals (Nutzkanals) bzw. der Unterdrückung von Nachbarkanälen und andererseits der Rauschbandbegrenzung. Hierzu wird die Bandbreite des komplexwertigen Bandpaßsignals xIFc in der Filtereinheit 22 mit Hilfe einer komplexen Butterworth-Filterung dritter Ordnung auf ca. 2 MHz beschränkt. Eine solche Filtereinheit 22 ist einfach zu realisieren und energiesparend zu betreiben. Vorzugsweise werden die Werte des Realteils des gefilterten Signals anschließend in der Filtereinheit 22 mit Hilfe eines sog. Limiter-Verstärkers verstärkt und derart auf einen Maximalwert begrenzt, daß die Realteilwerte den Maximalwert betragsmäßig nicht übersteigen.

Da nur der Realteil (xIFr) des gefilterten Signals gebildet und weiterverarbeitet wird, wird die in Figur 2 dargestellte Empfangseinheit 16 als "reellwertige low IF"-Empfangseinheit bezeichnet. Durch die Realteilbildung vereinfacht sich der Aufbau der nachfolgenden Funktionsblöcke und damit der gesamten Empfangseinheit wesentlich. So wird vorteilhaft insbesondere nur ein Analog-Digital-Wandler für die nachfolgende Signalverarbeitung benötigt.

In Figur 3b ist die spektrale Leistungsdichte des reellwertigen Bandpaßsignals xIFr schematisch dargestellt. Durch die Realteilbildung ergibt sich ein konjugiert gerades Spektrum und damit eine bezüglich der Frequenz f=0 symmetrische spektrale Leistungsdichte.

Das reellwertige Bandpaßsignal xIFr wird durch den Analog/Digital-Wandler 23 vorzugsweise mit einer Abtastrate von 16 Msps (megasamples per second) bzw. einer Abtastfrequenz von 16 MHz abgetastet (d.h. mit einem ganzzahligen Vielfachen der Zwischenfrequenz fIF) und mit einer Bitbreite N von nur einem Bit quantisiert. Wegen der Digitalisierung im Zwischenfrequenzbereich wird die in Fig. 2 dargestellte Empfangseinheit 16 auch als "digitale low IF"-Empfangseinheit bezeichnet. Simulationen der Anmelderin haben gezeigt, daß sich die Empfängerempfindlichkeit infolge der Quantisierung mit N=1 Bit nur unwesentlich verschlechtert gegenüber dem theoretischen Fall einer Quantisierung mit unendlicher Präzision (Auflösung). Die spektrale Leistungsdichte des resultierenden digitalen IF-Signals xD ist schematisch in Figur 3c als Funktion der normierten Kreisfrequenz $\Omega = 2\pi^* (f/fS)$ dargestellt, wobei der Wert $\Omega = \pi$ einer unnormierten Frequenz von f=fS/2=8 MHz entspricht. Da auch das digitale Signal xD reellwertig ist, ergibt sich auch hier eine bezüglich $\Omega = 0$ symmetrische ("gerade") spektrale Leistungsdichte. Neben den schraffiert dargestellten Nutzbandanteilen um $\Omega = \pm\pi/4$ bzw. $f = \pm fS/8 = \pm fIF = \pm 2$ MHz sind in Figur 3c nicht schraffierte Störanteile infolge der Quantisierung mit nur einem Bit (N=1) zu erkennen.

Die digitale Filtereinheit 24 filtert das digitale Signal xD mittels einer komplexwertigen FIR-Filterung (finite impulse response) derart, daß Signalanteile au-ßerhalb des Nutzbandes, die z.B. durch die Quantisierung bei der Analog/Digital-Wandlung entstanden sind, unterdrückt werden und stellt ein komplexwertiges gefiltertes Signal xF bereit. Die digitale Filtereinheit 24 ist als Lookup-Table realisiert und weist ein mit dem ADC 23 verbundenes binäres Schieberegister und einen mit dem Schieberegister, dem ADC 23 und der Ratenreduktionseinheit 25 verbundenen Speicher auf, in dem sämtliche möglichen Werte des gefilterten Signals xF gespeichert sind. Simulationen der Anmelderin haben gezeigt, daß die FIR-Filterung vorteilhaft mit sechs Filterkoeffizienten durchgeführt werden kann. In diesem Falle bilden jeweils sechs aufeinanderfolgende Bitwerte des digitalen Signals xD eine Adresse, mit deren Hilfe genau einer der insgesamt $2^6 = 64$ gespeicherten komplexen Werte aus dem Speicher ausgelesen und als Wert des gefilterten Signals xF bereitgestellt wird. Die Adresse setzt sich hierbei aus dem jeweils aktuellen Bitwert von xD und den jeweils 5 vorherigen Bitwerten, die im binären Schieberegister der Länge 5 zwischengespeichert werden, zusammen. Mit einer solchen Filterung, die keinerlei arithmetische Operationen erfordert, wird die Bandbreite des digitalen Signals xD auf ca. 2 MHz beschränkt und eine Dämpfung von ca. 20dB erzielt. Die spektrale Leistungsdichte des gefilterten Signals xF ist als Funktion der normierten Kreisfrequenz $\Omega$ schematisch in Figur 3d dargestellt. Da das gefilterte Signal xF komplexwertig ist, ergibt sich eine spektrale Leistungsdichte, die bezüglich $\Omega = 0$ nicht symmetrisch ist. Neben dem schraffiert darge- stellten Nutzbandanteil um $\Omega = +\pi/4$ bzw. f=fS/8 =fIF=2 MHz ist in Figur 3d anhand der nicht schraffierten Bereiche schematisch zu ersehen, daß die Quantisierungs-Störanteile durch die Filterung gedämpft wurden.

Die Abtastratenreduktionseinheit 25 ist ausgebildet, das komplexwertige gefilterte Signal xF in seiner Abtastrate um einen Faktor M $\geq$ 2 zu reduzieren und ein ratenreduziertes Signal xR bereitzustellen. Das ebenfalls komplexwertige ratenreduzierte Signal xR wird schließlich mittels der Mischereinheit 26 spektral (um 2MHz nach links) in das Basisband verschoben und so das komplexwertige digitale Basisbandsignal xBB generiert.

Gemäß eines ersten, bevorzugten Ausführungsbeispiels wird die Abtastrate des gefilterten Signals xF in der Abtastratenreduktionseinheit 25 um einen Faktor M = 2 auf 16 Msps / 2 = 8 Msps reduziert. Hierdurch kann die Mischereinheit 26 sehr einfach realisiert werden. Die für die Basisbandmischung an sich erforderliche Multiplikation mit einer komplexen Exponentialfolge vereinfacht sich im Falle des ersten Ausführungsbeispiels (Abtastrate=4*fC=8 Msps) vorteilhaft zu einer Multiplikation mit dem zeitvarianten Faktor

$$\exp(-j*k*\pi/2) = (-j)^k , \qquad\qquad (1)$$

wobei exp($\cdot$) die komplexe Exponentialfunktion und k den zeitlichen Index des Wertes des ratenreduzierten Signals xR bezeichnen. Je nach Wert des Index k ist der zugehörige komplexe Wert von xR also mit einem der Werte $\{\pm 1, \pm j\}$ zu multiplizieren, so daß die Mischereinheit 26 nur in der Lage sein muß, das Vorzeichen von Real- und/oder Imaginärteil des Wertes von xR zu wechseln und/oder den Realteil mit dem Imaginärteil zu tauschen. Keine dieser Operationen erfordert arithmetische Operationen wie Additionen und Multiplikationen.

Die spektrale Leistungsdichte des digitalen Basisbandsignals xBB ist schematisch in Figur 3e als Funktion der normierten Kreisfrequenz $\Omega$' = M*$\Omega$ = 4$\pi$*(f/fS) dargestellt, wobei der Wert $\Omega$'= $\pi$ einer unnormierten Frequenz von f=fS/M/2 =fS/4= 4 MHz entspricht. Da das Basisbandsignal xBB komplexwertig ist, ergibt sich eine bezüglich $\Omega$' = 0 nicht symmetrische spektrale Leistungsdichte. Der wiederum schraffiert dargestellte Nutzbandanteil um $\Omega$' = 0 (Basis- band) erstreckt sich wegen der Ratenreduzierung um den Faktor M=2 nunmehr von $\Omega$' = -$\pi$/4 bis $\Omega$' = +$\pi$/4. Dies entspricht einem Frequenzbereich von f=-fS/16 = -1 MHz bis +1 MHz.

In einem zweiten Ausführungsbeispiel wird die Abtastrate des gefilterten Signals xF in der Abtastratenreduktionseinheit 25 um einen Faktor M = 4 auf 16 Msps / 4 = 4 Msps reduziert, d.h. auf die zweifache Chiprate fC. In diesem Falle vereinfacht sich die komplexe Multiplikation zu einer Multiplikation mit

$$\exp(-j*k*\pi) = (-1)^k , \qquad\qquad (2)$$

 d.h. zu einem Vorzeichenwechsel von Real- und Imaginärteil jedes zweiten Wertes von xR, nämlich derjenigen mit ungeradem Index k. Auch in diesem Fall sind also keine arithmetischen Operationen erforderlich.

Das digitale Basisbandsignal xBB weist mit 8 Msps (erstes Ausführungsbeispiel) bzw. 4 Msps (zweites Ausführungsbeispiel) eine Rate auf, die der vier- bzw. zweifachen Chiprate fC entspricht (fC=2Mchip/s). Dieses Signal xBB wird der Demodulationseinheit 28 und einer nicht in Figur 2 dargestellten Synchronisationseinheit zugeführt. Die Synchronisationseinheit bestimmt mit Hilfe einer Korrelation von xBB mit einer sog. Präambelsequenz der Datenrahmen eine optimale der insgesamt vier bzw. zwei Abtastphasen, damit das digitale Basisbandsignal xBB in der Demodulationseinheit 28 mit der optimalen Phase um den Faktor vier bzw. zwei unterabgetastet werden kann.

Das resultierende Chiptaktsignal wird anschließend mittels eines MSK-Demodulators in der Demodulationseinheit 28 demoduliert und durch die Korrelationseinheit 29 entspreizt, d.h. mit PN-Sequenzen korreliert. Die gesendeten Daten werden schließlich in der Detektionseinheit 30 detektiert (entschieden), indem die Korrelationsergebnisse ausgewertet und dem maximalen Korrelationsergebnis der entsprechende Daten(symbol)wert bzw. die entsprechenden Datenbits zugeordnet werden.

Obgleich die vorliegende Erfindung vorstehend anhand von Ausführungsbeispielen beschrieben wurde, ist sie nicht darauf beschränkt, sondern auf vielfältige Weise modifizierbar. So ist die Erfindung beispielsweise weder auf WPANs an sich, noch auf WPANs gemäß IEEE 802.15.4 bzw. die dort spezifizierten Bandspreiz-, Modulations- und Multiplex-Zugriffsverfahren, Frequenzbänder, Bit-, Symbol- und Chipraten und -stufigkeiten, noch auf die angegebenen Werte der Zwischenfrequenz, der Abtastfrequenz, Filterbandbreiten, -typen und -ordnungen etc. beschränkt. Die Erfindung kann vielmehr in unterschiedlichsten drahtlosen oder -gebundenen digitalen Kommunikationssystemen vorteilhaft eingesetzt werden.

Bezugszeichenliste

|  |  |
|---|---|
| 10 | Datenübertragungssystem / "Wireless Personal Area Network" (WPAN) nach dem IEEE-Standard 802.15.4 |
| 11-13 | Sende-/Empfangsvorrichtung (transceiver, TRX) |
| 14 | Antenne |
| 15 | Sendeeinheit (transmitter, TX) |
| 16 | Empfangseinheit (receiver, RX) |
| 17 | Kontrolleinheit (CTRL) |
| 20 | Vorrichtung zum Empfangen |
| 21 | Verstärker-/Mischereinheit |
| 22 | analoge Filtereinheit (CHSEL) |
| 23 | Analog-Digital-Wandler |
| 24 | digitale Filtereinheit (FIR) |
| 25 | Abtastratenreduktionseinheit |
| 26 | Mischereinheit |
| 27 | Datendetektionseinheit |
| 28 | Demodulationseinheit (DEMOD) |
| 29 | Korrelationseinheit (COR) |
| 30 | Detektionseinheit (DET) |

|  |  |
|---|---|
| ADC | Analog-/Digital-Wandler |
| BB | Basisband |
| BP | Bandpaß |
| CHSEL | channel selection (Kanalselektion) |
| COR | Korrelationseinheit, Despreader |
| CTRL | Kontrolleinheit |
| DEMOD | Demodulator |
| DET | Detektor |
| FIR | finite impulse response |
| IF | intermediate frequency (Zwischenfrequenz) |
| ISM | industrial, scientific, medical (Frequenzband bei 2,4 GHz) |
| LNA | low noise amplifier |
| Mchip/s | Megachip per second |
| MSK | minimum shift keying |
| Msps | Megasamples per second |
| PN | pseudo-noise |
| PSD | power spectral density, spektrale Leistungsdichte |
| QPSK | quarternary phase shift keying |
| RF | Funkfrequenz |
| RX | Empfangseinheit |
| TP | Tiefpaß |
| TRX | Sende-/Empfangsvorrichtung, transceiver |
| TX | Sendeeinheit, transmitter |
| WPAN | Wireless Personal Area Network |

|  |  |
|---|---|
| $\Omega$ | normierte Kreisfrequenz $\Omega = 2\pi^*(f/fS)$ |
| $\Omega'$ | normierte Kreisfrequenz $\Omega' = M^*\Omega = 4\pi^*(f/fS)$ |
| d | Datensymbole/-bits |
| exp($\cdot$) | komplexe Exponentialfunktion |
| f | Frequenz |
| fC | Chiprate; Chiptakt |
| fIF | Zwischenfrequenz |

| fRF | Funkfrequenz |
|---|---|
| fS | Abtastfrequenz |
| k | zeitlicher Index |
| M | Faktor der Ratenreduzierung / Unterabtastung |
| xBB | komplexwertiges digitales Basisbandsignal |
| xD | reellwertiges digitales Signal |
| xF | komplexwertiges gefiltertes Signal |
| XIFC | komplexwertiges Bandpaß-/Zwischenfrequenzsignal |
| xIFr | reellwertiges Bandpaß-/Zwischenfrequenzsignal |
| xR | komplexwertiges ratenreduziertes Signal |
| xRF | Funksignal |

**Patentansprüche**

1. Vorrichtung (20) zum Überführen eines komplexwertigen Bandpaßsignals (XIFc) in ein digitales Basisbandsignal (xBB), enthaltend:

   a) eine analoge Filtereinheit (22), die ausgebildet ist, das komplexwertige Bandpaßsignal (xIFc) derart zu filtern, daß Signalanteile außerhalb des Nutzbandes unterdrückt werden, vom gefilterten Signal nur den Realteil zu bilden und ein reellwertiges Bandpaßsignal (xIFr) bereitzustellen,
   b) genau einen mit der analogen Filtereinheit (22) verbundenen Analog-Digital-Wandler (23), der ausgebildet ist, das reellwertige Bandpaßsignal (xIFr) in ein digitales Signal (xD) mit ein Bit breiten Abtastwerten zu überführen,
   c) eine mit dem Analog-Digital-Wandler (23) verbundene und als Lookup-Table ausgestaltete digitale Filtereinheit (24), die ausgebildet Ist, ein komplexwertiges gefiltertes Signal (xF) bereitzustellen, Indem das digitale Signal (xD) mittels einer komplexwertigen FIR-Filterung derart gefiltert wird, daß sigrialanteile außerhalb des Nutzbandes unterdrückt werden,
   d) eine mit der digitalen Filtereinheit (24) verbundene Abtastratenreduktionseinheit (25), die ausgebildet ist, das komplexwertige gefilterte Signal (xF) in seiner Abtastrate zu reduzieren und ein ratenreduziertes Signal (xR) bereitzustellen,
   e) eine mit der Abtastratenreduktionseinheit (25) verbundene Mischereinheit (26), die ausgebildet ist, das ratenreduzierte Signal (xR) in das digitale Basisbandsignal (xBB) zu überführen.

2. Vorrichtung nach Anspruch 1, **dadurch gekennzeichnet, daß** die analoge Filtereinheit (22) ausgebildet ist, das komplexwertige Bandpaßsignal (x1Fc) mittels einer Butterworth-Filterung dritter Ordnung zu filtern.

3. Vorrichtung nach einem der vorhergehenden Ansprüche, **dadurch gekennzeichnet, daß** die analoge Filtereinheit (22) ausgebildet ist, das reellwertige Bandpaßsignal (xIFr) zu bilden, indem die Werte des Realteils des gefilterten Signals auf einen Maximalwert begrenzt werden.

4. Vorrichtung nach einem der vorhergehenden Ansprüche, **dadurch gekennzeichnet, daß** der Analog-Digital-Wandler (23) ausgebildet ist, das reellwertige Bandpaßsignal (xIFr) mit einer Abtastrate von 16 Msps abzutasten.

5. Vorrichtung nach einem der vorhergehenden Ansprüche, **dadurch gekennzeichnet, daß** die digitale Filtereinheit (24) ein mit dem Analog-Digital-Wandler (23) verbundenes binäres Schieberegister und einen mit dem binären Schieberegister und der Abtastratenreduktionseinheit (25) verbundenen Speicher aufweist.

6. Vorrichtung nach Anspruch 5, wobei das binäre Schieberegister ausgebildet ist, fünf Werte des digitalen Signals (xD) zu speichern und wobei der Speicher ausgebildet ist, 64 komplexe Werte zu speichern.

7. Vorrichtung nach einem der vorhergehenden Ansprüche, **dadurch gekennzeichnet, daß** die Mischereinheit (26) ausgebildet ist, das Vorzeichen von Real- und/oder Imaginärteil eines wertes des ratenreduzierten Signals (xR) zu wechseln.

8. Vorrichtung nach einem der vorhergehenden Ansprüche, wobei

   a) die Abtastratenreduktionseinheit (25) ausgebildet ist, das komplexwertlge gefilterte Signal (xF) in seiner Abtastrate um einen Faktor (M) von zwei zu reduzieren,
b) die Mischereinheit (26) ausgebildet ist, den Realteil mit dem Imaginärteil eines Wertes des ratenreduzierten signals (xR) zu tauschen und/oder das Vorzeichen von Real- und/oder Imaginärteil des Wertes zu wechseln.

**9.** Vorrichtung nach einem der Ansprüche 1 bis 7, wobei

a) die Abtastratenreduktionseinheit (25) ausgebildet ist, das komplexwertige gefilterte Signal (xF) in seiner Abtastrate um einen Faktor (M) von vier zu reduzieren,
b) die Mischereinheit (26) ausgebildet ist, das Vorzeichen von Real- und Imaginärteil jedes zweiten Wertes des ratenreduzierten Signals (xR) zu wechseln.

**10.** Vorrichtung nach einem der vorhergehenden Ansprüche, wobei das komplexwertige Bandpaßsignal (xIFc) eine Mittenfrequenz (fIF) von im wesentlichen 2 MHz aufweist.

**11.** Sende-/Empfangsvorrichtung (11-13) beinhaltend:

a) eine Antenne (14),
b) eine mit der Antenne (14) verbundene Sendeeinheit (15) zum Senden von Daten,
c) eine mit der Antenne (14) verbundene Empfangseinheit (16) mit einer Vorrichtung nach einem der Ansprüche 1 bis 10,
d) eine mit der Sendeeinheit (15) und der Empfangseinheit (16) verbundene Kontrolleinheit (17) zur Steuerung der Sendeeinheit (15) und der Empfangseinheit (16).

**12.** Sende-/Empfangsvorrichtung nach Anspruch 11, derart ausgestaltet, dass sie zur Kommunikation mit einem Datenübertragungssystem (10) nach dem IEEE-Standard 802.15.4 fähig ist.

**13.** integrierte Schaltung mit einer Vorrichtung nach einem der Ansprüche 1 bis 10.

**Claims**

**1.** Device (20) for converting a complex significance bandpass signal (xIFc) into a digital base band signal (xBB), comprising:

a) an analog filter unit (22) constructed to filter the complex significance bandpass signal (xIFc) in such a manner that signal components outside the useful band are suppressed, to form only the real part from the filtered signal and to provide a real significance bandpass signal (xIFr),
b) exactly one analog-to-digital converter (23) which is connected with the analog filter unit (22) and which is constructed to convert the real significance bandpass signal (xIFr) into a digital signal (xD) with scanning values of bit width,
c) a digital filter unit (24) which is connected with the analog-to-digital converter (23) and formed as a look-up table and which is constructed to provide a complex significance filtered signal (xF) in that the digital signal (xD) is filtered by means of a complex significance FIR filtering in such a manner that signal components outside the useful band are suppressed,
d) a scanning rate reduction unit (25) which is connected with the digital filter unit (24) and which is constructed to reduce the complex significance filtered signal (xF) in its scanning rate and to provide a rate-reduced signal (xR) and
e) a mixer unit (26) which is connected with the scanning rate reduction unit (25) and which is constructed to convert the rate-reduced signal (xR) into the digital base band signal (xBB).

**2.** Device according to claim 1, **characterised in that** the analog filter unit (22) is constructed to filter the complex significance bandpass signal (xIfc) by means of a Butterworth filtering of third order.

**3.** Device according to one of the preceding claims, **characterised in that** the analog filter unit (22) is constructed to form the real significance bandpass signal (xIFr) **in that** the values of the real part of the filtered signal are limited to a maximum value.

**4.** Device according to one of the preceding claims, **characterised in that** the analog-to-digital converter (3) is constructed to scan the real significance bandpass signal (xIFr) at a scanning rate of 16 Msps.

5. Device according to one of the preceding claims, **characterised in that** the digital filter unit (24) comprises a binary shift register connected with the analog-to-digital converter (23) and a memory connected with the binary shift register and the scanning rate reduction unit (25).

6. Device according to claim 5, wherein the binary shift register is constructed to store five values of the digital signal (xD) and wherein the memory is constructed to store 64 complex values.

7. Device according to one of the preceding claims, **characterised in that** the mixer unit (26) is constructed to change the sign of real and/or imaginary part of a value of the rate-reduced signal (xR).

8. Device according to one of the preceding claims, wherein

a) the scanning rate reduction unit (25) is constructed to reduce the complex significance filtered signal (xF) in its scanning rate by a factor (M) of two and
b) the mixer unit (26) is constructed to exchange the real part for the imaginary part of a value of the rate-reduced signal (xR) and/or to change the sign of real and/or imaginary part of the value.

9. Device according to one of claims 1 to 7, wherein

a) the scanning rate reduction unit (25) is constructed to reduce the complex significance filtered signal (xF) in its scanning rate by a factor (M) of four and
b) the mixer unit (26) is constructed to change the sign of real and imaginary part of each second value of the rate-reduced signal (xR).

10. Device according to one of the preceding claims, wherein the complex significance bandpass signal (xIFc) has a mean frequency (fIF) of substantially 2 MHz.

11. Transmitter/receiver device (11-13) including:

a) an antenna (14),
b) a transmitter unit (15), which is connected with the antenna (14), for transmitting data,
c) a receiver unit (16), which is connected with the antenna (14), with a device according to one of claims 1 to 10 and
d) a control unit (17), which is connected with the transmitter unit (15) and the receiver unit (16), for controlling the transmitter unit (15) and the receiver unit (16).

12. Transmitter/receiver device according to claim 11, **characterised in that** it is capable of communication with a data transmission system (10) according to the IEEE standard 802.15.4

13. Integrated circuit with a device according to one of claims 1 to 10.

**Revendications**

1. Dispositif (20) pour la conversion d'un signal de bande passante à valeurs complexes (xIFc) en un signal de bande de base numérique (xBB), comprenant:

a) une unité de filtrage analogique (22), conçue pour filtrer le signal de bande passante à valeurs complexes (xIFc) de telle manière que les parties du signal en dehors de la bande utile sont supprimées, pour ne former que la partie réelle du signal filtré et pour fournir un signal de bande passante à valeurs réelles (xIFr),
b) un seul convertisseur analogique/numérique connecté à l'unité de filtrage analogique (22), conçu pour convertir le signal de bande passante à valeurs réelles (xIFr) en un signal numérique (xD) à valeurs de balayage d'un bit de largeur,
c) une unité de filtrage numérique (24) reliée au convertisseur analogique/numérique (23) et configurée en tant que table de conversion, conçue pour fournir un signal filtré (xF) à valeurs complexes en filtrant le signal digital (xD) au moyen d'un filtrage FIR à valeurs complexes de telle manière que les parties du signal en dehors de la bande utile sont supprimées,

d) une unité de réduction du taux de balayage (25) reliée à l'unité de filtrage numérique (24), conçue pour réduire le signal filtré à valeurs complexes (xF) dans son taux de balayage et pour fournir un signal à taux réduit (xR),

e) un mélangeur (26) relié à l'unité de réduction du taux de balayage (25), conçue pour convertir le signal à taux réduit (xR) en le signal de bande de base numérique (xBB).

2. Dispositif selon la revendication 1, **caractérisé en ce que** l'unité de filtrage analogique (22) est conçue pour filtrer le signal de bande passante à valeurs complexes (xIFc) au moyen d'un filtrage de type Butterworth de troisième niveau.

3. Dispositif selon l'une quelconque des revendications précédentes, **caractérisé en ce que** l'unité de filtrage analogique (22) est conçue pour former le signal de bande passante à valeurs réelles (xIFr) en limitant les valeurs de la partie réelle du signal filtré à une valeur maximale.

4. Dispositif selon l'une quelconque des revendications précédentes, **caractérisé en ce que** le convertisseur analogique/numérique (23) est conçu pour balayer le signal de bande passante à valeurs réelles (xIFr) avec un taux de balayage de 16 Msps.

5. Dispositif selon l'une quelconque des revendications précédentes, **caractérisé en ce que** l'unité de filtrage numérique (24) présente un registre binaire à décalage relié au convertisseur analogique/numérique (23) et une mémoire reliée au registre binaire à décalage et à l'unité de réduction du taux de balayage (25).

6. Dispositif selon la revendication 5, dans lequel le registre binaire à décalage est conçu pour mémoriser cinq valeurs du signal numérique (xD) et la mémoire est conçue pour mémoriser 64 valeurs complexes.

7. Dispositif selon l'une quelconque des revendications précédentes, **caractérisé en ce que** le mélangeur (26) est conçu pour modifier le signe de la partie réelle et/ou imaginaire d'une valeur du signal à taux réduit (xR).

8. Dispositif selon l'une quelconque des revendications précédentes dans lequel,

a) l'unité de réduction de taux de balayage (25) est conçue pour réduire d'un facteur (M) deux le taux de balayage du signal filtré à valeurs complexes (xF),

b) le mélangeur (26) est conçu pour remplacer la partie réelle d'une valeur du signal à taux réduit (xR) par sa partie imaginaire et/ou à changer le signe de la partie réelle et/ou imaginaire de la valeur.

9. Dispositif selon l'une quelconque des revendications 1 à 7, dans lequel

a) l'unité de réduction du taux de balayage (25) est conçue pour réduire d'un facteur (M) quatre le taux de balayage du signal filtré à valeurs complexes (xF),

b) le mélangeur (26) est conçu pour changer le signe de la partie réelle et imaginaire d'une valeur sur deux du signal à taux réduit (xR).

10. Dispositif selon l'une quelconque des revendications précédentes, dans lequel le signal de bande passante à valeurs multiples (xIFc) présente une fréquence médiane (fIF) de sensiblement 2 MHz.

11. Dispositif émetteur/récepteur (11-13) comprenant :

a) une antenne (14),

b) une unité émettrice (15) reliée à l'antenne (14) pour l'émission de données,

c) une unité réceptrice (16) reliée à l'antenne (14) comprenant un dispositif selon l'une quelconque des revendications 1 à 10,

d) une unité de contrôle (17) reliée à l'unité émettrice (15) et à l'unité réceptrice (16) pour commander l'unité émettrice (15) et l'unité réceptrice (16).

12. Dispositif émetteur/récepteur selon la revendication 11, conçu de manière à pouvoir communiquer avec un système de transmission de données (10) selon le standard IEEE 802.15.4.

**13.** Circuit intégré comprenant un dispositif selon l'une quelconque des revendications 1 à 10.

FIG. 1

FIG. 2

FIG. 3

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0243259 A2